# EUROPEAN PATENT APPLICATION

(11) **EP 4 583 168 A1**
(43) Date of publication of application: **09.07.2025**
(21) Application number: 22955190.8
(22) Date of filing: 31.08.2022
(51) Int. Cl.: H01L 31/0463, H01L 31/0352

(54) **SOLAR CELL, MULTI-JUNCTION SOLAR CELL, SOLAR CELL MODULE, AND SOLAR CELL POWER GENERATION SYSTEM**

(71) Applicant: Kabushiki Kaisha Toshiba, Minato-ku Tokyo 105-0023 (JP); Toshiba Energy Systems & Solutions Corporation, Kawasaki-shi, Kanagawa 212-0013 (JP)
(72) Inventor: YOSHIO, Sara, Tokyo 1050023 (JP); WADA, Atsushi, Tokyo 1050023 (JP); HONISHI, Yuya, Tokyo 1050023 (JP); SHIBASAKI, Soichiro, Tokyo 1050023 (JP); NAKAGAWA, Naoyuki, Tokyo 1050023 (JP); MIZUNO, Yukitami, Tokyo 1050023 (JP); YAMAZAKI, Mutsuki, Tokyo 1050023 (JP); WAKAMATSU, Kodai, Tokyo 1050023 (JP); NISHIDA, Yasutaka, Tokyo 1050023 (JP); YAMAMOTO, Kazushige, Tokyo 1050023 (JP)
(74) Representative: Hoffmann Eitle
(86) International application number: PCT/JP2022/032766
(87) International publication number: WO 2024/047795

(57) **Abstract**

According to one embodiment of the invention, a solar cell includes a first conductive layer, a first counter conductive layer, and a first photoelectric conversion layer. The first counter conductive layer includes a first conductive region. A direction from the first conductive layer to the first conductive region is along a first direction. The first photoelectric conversion layer includes a first photoelectric conversion region and a second photoelectric conversion region. The first photoelectric conversion region is provided between the first conductive layer and the first conductive region in the first direction. The second photoelectric conversion region does not overlap the first conductive region in the first direction. A second thickness of the second photoelectric conversion region along the first direction is thinner than a first thickness of the first photoelectric conversion region along the first direction.

## Description

### [Technical Field]

The embodiments of the invention relate to a solar cell, a multi-junction type solar cell, a solar cell module, and a solar cell power generation system.

### [Background Art]

It is desired to improve efficiency in a solar cell.

### [Prior Art Document]

### [Patent Document]

[Patent Document 1] JP 2020-508559 A

### [Summary of Invention]

### [Problem to be Solved by Invention]

The embodiments of the invention provide a solar cell, a multi-junction type solar cell, a solar cell module, and a solar cell power generation system in which the efficiency can be improved.

### [Means for Solving Problem]

According to one embodiment of the invention, a solar cell includes a first conductive layer, a first counter conductive layer, and a first photoelectric conversion layer. The first counter conductive layer includes a first conductive region. A direction from the first conductive layer to the first conductive region is along a first direction. The first photoelectric conversion layer includes a first photoelectric conversion region and a second photoelectric conversion region. The first photoelectric conversion region is provided between the first conductive layer and the first conductive region in the first direction. The second photoelectric conversion region does not overlap the first conductive region in the first direction. A second thickness of the second photoelectric conversion region along the first direction is thinner than a first thickness of the first photoelectric conversion region along the first direction.

### [Brief Description of Drawings]

[FIG. 1]

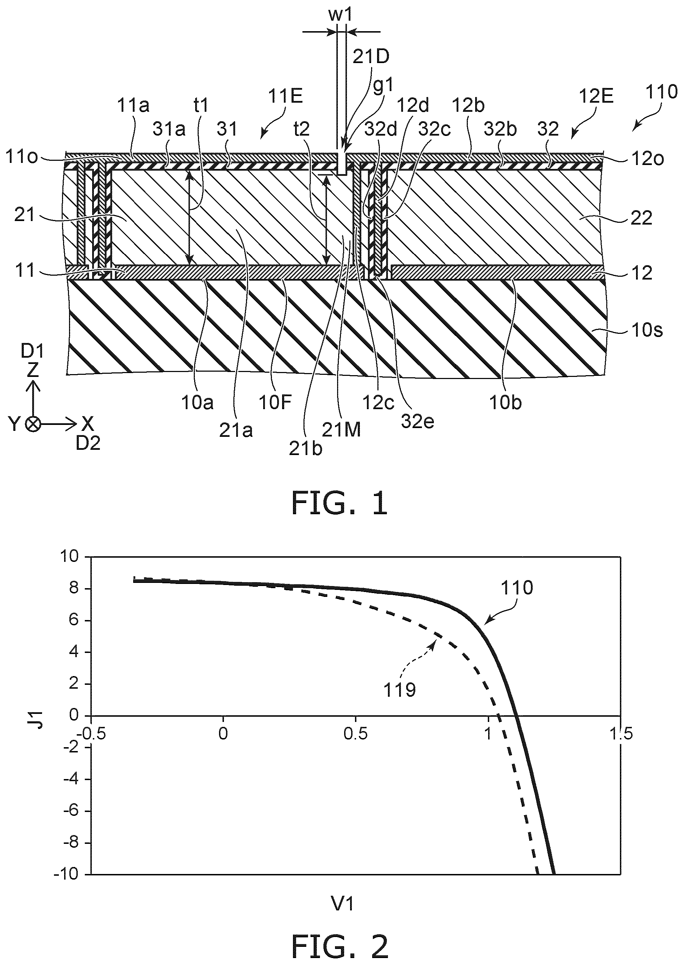

   FIG. 1 is a schematic cross-sectional view illustrating a solar cell according to a first embodiment.
[FIG. 2]
   FIG. 2 is a graph illustrating characteristics of the solar cell.
[FIG. 3]

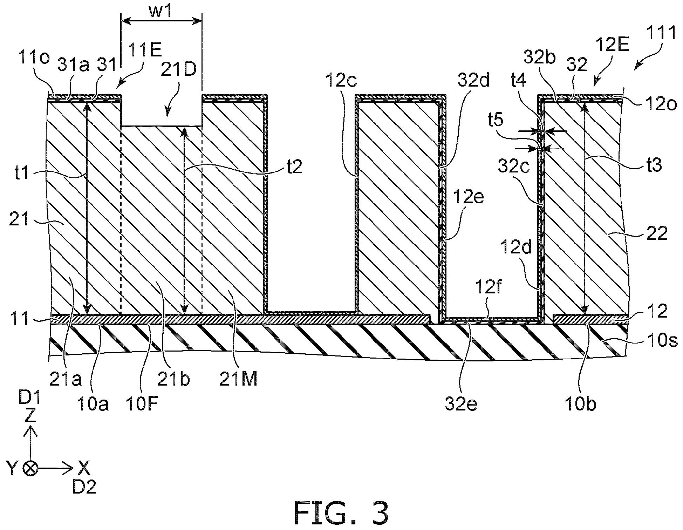

   FIG. 3 is a schematic cross-sectional view illustrating a solar cell according to the first embodiment.
[FIG. 4]

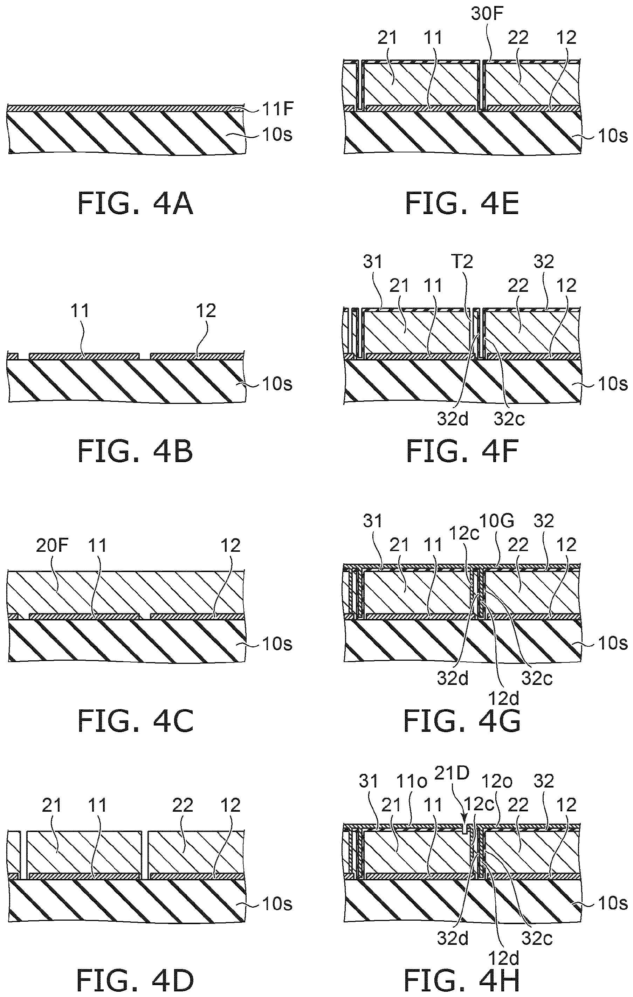

   FIG. 4A to FIG. 4H are schematic cross sectional views illustrating a manufacturing method of the solar cell according to the first embodiment.
[FIG. 5]

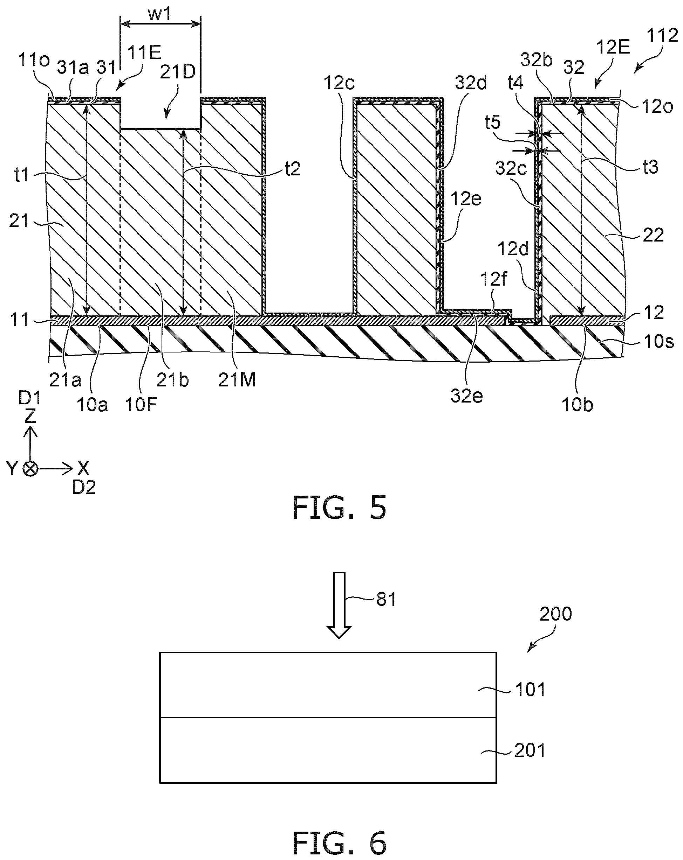

   FIG. 5 is a schematic cross-sectional view illustrating a solar cell according to the first embodiment.
[FIG. 6]
   FIG. 6 is a schematic cross sectional view illustrating a multi-junction type solar cell according to a second embodiment.
[FIG. 7]

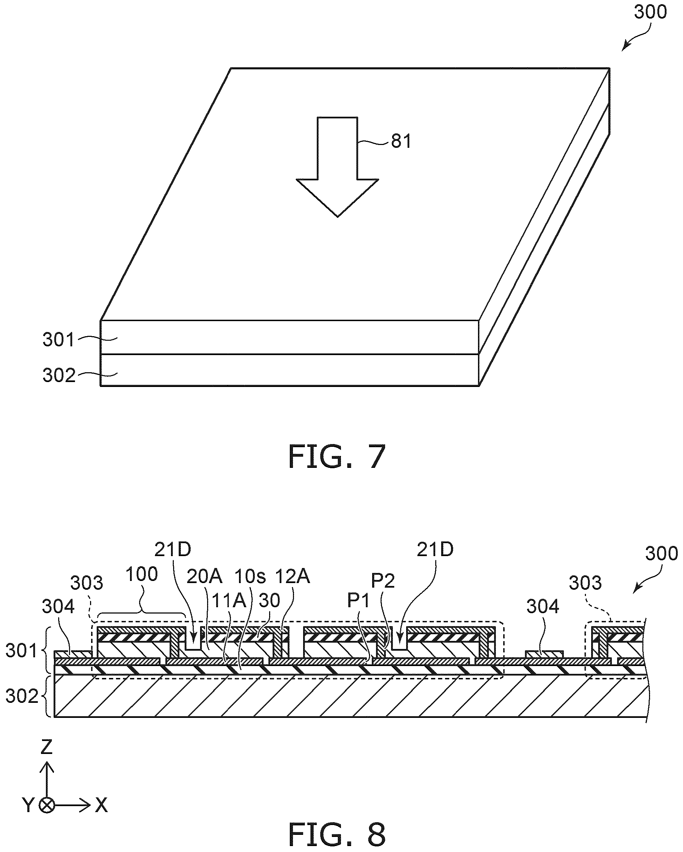

   FIG. 7 is a schematic perspective view illustrating a solar cell module according to a third embodiment.
[FIG. 8]
   FIG. 8 is a schematic cross sectional view illustrating a solar cell module according to the third embodiment.
[FIG. 9]

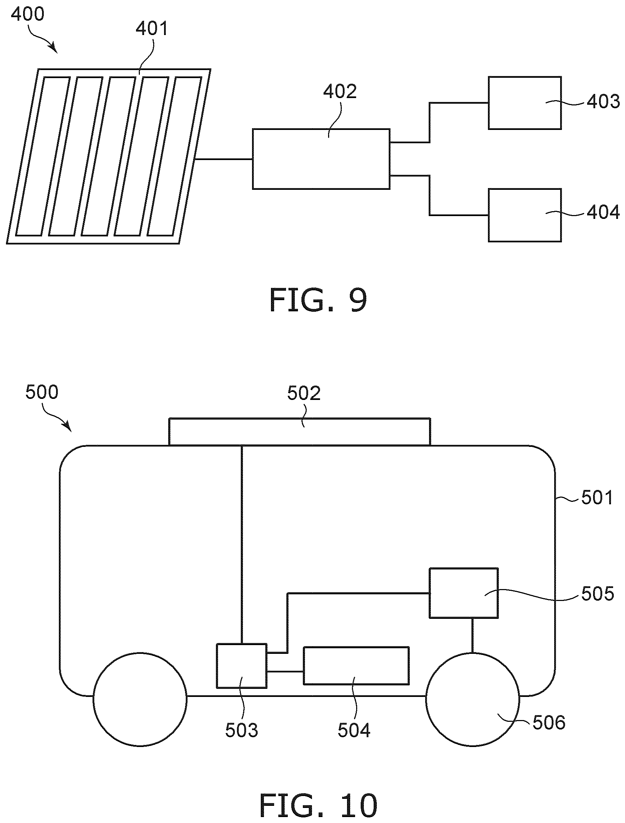

   FIG. 9 is a schematic view illustrating a solar cell power generation system according to a fourth embodiment.
[FIG. 10]
   FIG. 10 is a schematic view showing a usage example of the solar cell power generation system according to the fourth embodiment.

### [Embodiments of Invention]

Various embodiments of the invention are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### First embodiment

FIG. 1 is a schematic cross sectional view illustrating a solar cell according to a first embodiment.

As shown in FIG. 1, a solar cell 110 according to the embodiment includes a first conductive layer 11, a first counter conductive layer 11o, a first photoelectric conversion layer 21, a second conductive layer 12, a second counter conductive layer 12o, and a second photoelectric conversion layer 22.

The first counter conductive layer 11o includes a first conductive region 11a. A direction from the first conductive layer 11 to the first conductive region 11a is along a first direction D1.

The first direction D1 is defined as a Z-axis direction. One direction perpendicular to the Z-axis direction is defined as an X-axis direction. A direction perpendicular to the Z-axis direction and the X-axis direction is defined as a Y-axis direction.

The first photoelectric conversion layer 21 includes a first photoelectric conversion region 21a and a second photoelectric conversion region 21b. The first photoelectric conversion region 21a is provided between the first conductive layer 11 and the first conductive region 11a in the first direction D1. The second photoelectric conversion region 21b does not overlap the first conductive region 11a in the first direction D1. A region overlapping the first conductive region 11a in the first direction D1 corresponds to the first photoelectric conversion region 21a. A region that does not overlap the first conductive region 11a in the first direction D1 corresponds to the second photoelectric conversion region 21b.

A thickness along the first direction D1 of the first photoelectric conversion region 21a is defined as a first thickness t1. A thickness along the first direction D1 of the second photoelectric conversion region 21b is defined as a second thickness t2. In the embodiment, the second thickness t2 is thinner than the first thickness t1.

A second direction D2 from the first conductive layer 11 to the second conductive layer 12 crosses the first direction D1. The second direction D2 is, for example, the X-axis direction.

The second counter conductive layer 12o includes a second conductive region 12b and a third conductive region 12c. A direction from the second conductive layer 12 to the second conductive region 12b is along the first direction D1. A direction from the first conductive region 11a to the second conductive region 12b is along the second direction D2. The third conductive region 12c electrically connects the second conductive region 12b with the first conductive layer 11. For example, at least a part of the third conductive region 12c extends along the first direction D1.

The second photoelectric conversion layer 22 is provided between the second conductive layer 12 and the second conductive region 12b. The second photoelectric conversion region 21b is between the first photoelectric conversion region 21a and the second photoelectric conversion layer 22 in the second direction D2. At least a part of the third conductive region 12c is between the second photoelectric conversion region 21b and the second photoelectric conversion layer 22 in the second direction D2.

For example, the first conductive layer 11, the first counter conductive layer 11o, and the first photoelectric conversion layer 21 are included in a first cell 11E. The second conductive layer 12, the second counter conductive layer 12o and the second photoelectric conversion layer 22 are included in a second cell 12E. The first conductive layer 11 is electrically connected to the second counter conductive layer 12o. The first cell 11E is connected in series with the second cell 12E. Thereby, for example, a target voltage is obtained. Multiple cells are connected in series by the third conductive region 12c.

The second photoelectric conversion region 21b does not overlap the second conductive region 12b in the first direction D1. As shown in FIG. 1, a gap g1 is provided between the first conductive region 11a and the second conductive region 12b. A portion corresponding to the gap g1 corresponds to the second photoelectric conversion region 21b. A photoelectric conversion layer that exists when the gap g1 is viewed from the first counter conductive layer 11o toward the first conductive layer 11 corresponds to the second photoelectric conversion region 21b. As described above, in the embodiment, the second thickness t2 of the second photoelectric conversion region 21b is thinner than the first thickness t1 of the first photoelectric conversion region 21a. A recess 21D is provided in the second photoelectric conversion region 21b.

For example, a conductive film that becomes the first conductive region 11a and the second conductive region 12b is formed on the photoelectric conversion layer. By removing a part of the conductive film, the conductive film is divided. Thereby, the first conductive region 11a and the second conductive region 12b are obtained.

For example, a first reference example in which the recess 21D is not provided can be considered. In the first reference example, a photoelectric conversion layer having a uniform thickness is provided. In the first reference example, a part of the conductive film is removed so that the surface portion of the photoelectric conversion layer is not removed. Such processing conditions are extremely narrow and tend to leave conductive films to be removed. In such a first reference example, it is difficult to stably obtain the desired series connection. For example, leakage current is likely to occur.

By surely removing the target conductive film when a part of the conductive film is removed, leakage current can be suppressed and the target series connection can be obtained. In this case, a second reference example can be considered in which all of the photoelectric conversion layers immediately below the divided portion (gap g1) of the conductive film is removed. In the second reference example, the second photoelectric conversion region 21b is not provided, and a groove reaching the first conductive layer 11 is provided. The second reference example corresponds to the case where the second thickness t2 is 0, for example.

In the solar cell 110 according to the embodiment, the second photoelectric conversion region 21b corresponds to the recess 21D. The second thickness t2 is not zero. It has been found that such a solar cell 110 can obtain a higher efficiency than the second reference example.

FIG. 2 is a graph illustrating characteristics of the solar cell.

The horizontal axis of FIG. 2 is a voltage V1 (relative value) applied between two terminals provided in the configuration including the first cell 11E and the second cell 12E. One of the two terminals is electrically connected to, for example, the first counter conductive layer 11o. Another one of the two terminals is electrically connected to, for example, the second counter conductive layer 12o. The vertical axis of FIG. 2 is the obtained current density J1. FIG. 2 illustrates the characteristics of the solar cell 110 according to the embodiment and the characteristics of a solar cell 119 of the second reference example.

In the example of the solar cell 110, the first thickness t1 is 5.5 µm and the second thickness t2 is 4.8 µm. In the solar cell 119, the first thickness t1 is 5.5 µm and the second thickness t2 is 0 µm.

As shown in FIG. 2, it can be seen that the solar cell 110 has higher performance than the solar cell 119. The efficiency in the solar cell 110 is 1.4 times the efficiency in the solar cell 119.

In the solar cell 110, it is considered that the photoelectric conversion action occurs in at least a part of the second photoelectric conversion region 21b. It is considered that the charge obtained in at least a part of the second photoelectric conversion region 21b is extracted via the first conductive layer 11 and the first conductive region 11a. At least a part of the second photoelectric conversion region 21b corresponds to an active region. By providing the second photoelectric conversion region 21b, the active region can be enlarged as compared with the second reference example. As a result, it is considered that a higher efficiency than that of the second reference example can be obtained.

By making the second thickness t2 greater than 0 in this way, the high efficiency can be obtained. By making the second thickness t2 thinner than the first thickness t1 as described above, the conductive film can be stably divided. Leakage current can be suppressed. A solar cell capable of improving efficiency can be provided.

In the embodiment, a first ratio of the absolute value of the difference between the first thickness t1 and the second thickness t2 to the first thickness t1 is preferably not less than 0.2 and not more than 0.99, for example. When the first ratio is 0.2 or more, for example, the high efficiency can be obtained stably. When the first ratio is 0.99 or less, for example, reliable division of the conductive film can be obtained. The first ratio may be, for example, not less than 0.5 and not more than 0.99. In one example, the first ratio may be between 0.5 and 0.95. For example, the first ratio may be practically determined based on the obtained efficiency and machining accuracy based on machining conditions.

As shown in FIG. 1, a distance along the second direction D2 between the first conductive region 11a and the second conductive region 12b is defined as a distance w1. A second ratio of the second thickness t2 to the distance w1 is preferably not less than 0.02 and not more than 0.5. When the second ratio is not less than 0.02, high efficiency can be obtained stably. When the second ratio is not more than 0.5, for example, a decrease in effective area can be suppressed. Leakage current can be effectively suppressed. The second ratio may be not less than 0.05 and not more than 0.2. For example, it is easy to obtain stable processing. A decrease in the effective area can be effectively suppressed. The distance w1 may vary along the Z-axis direction. For example, the side surface of the recess 21D may be inclined with respect to the Z-axis direction. For example, when the side surface of the recess 21D is tapered, the distance w1 may be an average value in the Z-axis direction.

As shown in FIG. 1, the solar cell 110 may include a first member 21M. The first member 21M includes the same material as the material included in the first photoelectric conversion layer 21. The first member 21M is between the second photoelectric conversion region 21b and the third conductive region 12c in the second direction D2.

The first member 21M overlaps a part of the second conductive region 12b, for example, in the first direction D1. By providing the first member 21M, it is possible to increase the processing margin of the conductive film that becomes the first conductive region 11a and the second conductive region 12b. A practical solar cell with high productivity can be provided.

In the embodiment, at least one of the first photoelectric conversion layer 21 and the second photoelectric conversion layer 22 includes copper and oxygen, for example. For example, at least one of the first photoelectric conversion layer 21 and the second photoelectric conversion layer 22 may include Cu₂O. For example, at least one of the first photoelectric conversion layer 21 and the second photoelectric conversion layer 22 includes crystals including Cu₂O. By using such a material, high photoelectric conversion efficiency can be easily obtained.

For example, when the photoelectric conversion layer includes crystals, the workability of the photoelectric conversion layer is low. For example, as in the second reference example above, a part of the conductive film on the photoelectric conversion layer is removed, and the entire photoelectric conversion layer corresponding to the removed part is removed by a method such as laser irradiation. In this case, the conductive film on the surface is damaged, which easily causes a leakage current. For example, a part (surface portion) of the photoelectric conversion layer corresponding to the removed portion can be removed relatively easily by a method such as scribing.

As shown in FIG. 1, the solar cell 110 may include a first compound layer 31 and a second compound layer 32. The first compound layer 31 includes a first compound region 31a. The first compound region 31a is provided between the first photoelectric conversion layer 21 and the first conductive region 11a. The first compound region 31a is provided, for example, between the first photoelectric conversion region 21a and the first conductive region 11a.

The second compound layer 32 includes a second compound region 32b and a third compound region 32c. The second compound region 32b is provided between the second photoelectric conversion layer 22 and the second conductive region 12b. At least a part of the third compound region 32c is between the first conductive layer 11 and the second conductive layer 12 in the second direction D2. For example, at least a part of the third compound region 32c is between the third conductive region 12c and the second photoelectric conversion layer 22 in the second direction D2.

The first compound region 31a does not overlap the second photoelectric conversion region 21b in the first direction D1. A part of the compound film that becomes the first compound region 31a may be removed when the part of the conductive film is removed.

At least one of the first compound layer 31 and the second compound layer 32 includes, for example, at least one of oxide and sulfide. This oxide includes, for example, at least one selected from the group consisting of Ga, Al, B, In, Ti, Zn, Hf, Zr, Sn, Si and Ge.

At least one of the first compound layer 31 and the second compound layer 32 include, for example, at least one selected from the group consisting of Ga₂O₃, Ga₂O₃ including Al (e.g. GaAlO), Ga₂O₃ including Sn (e.g. GaSnO), ZnO, and ZnO including Sn (e.g. ZnSnO ). For example, the first compound region 31a and the second compound region 32b facilitate obtaining high charge extraction efficiency.

For example, the conductivity of the first compound layer 31 is lower than the conductivity of the first photoelectric conversion layer 21. The conductivity of the second compound layer 32 is lower than the conductivity of the second photoelectric conversion layer 22.

As described above, at least a part of the third compound region 32c is between the first conductive layer 11 and the second conductive layer 12 in the second direction D2. By providing a material with low conductivity between the first conductive layer 11 and the second conductive layer 12, a leakage current can be easily suppressed.

For example, at least one of the first compound layer 31 and the second compound layer 32 may be n-type.

As shown in FIG. 1, the solar cell 110 may further include a base body 10s. The base body 10s includes a first surface 10F. The first surface 10F includes a first base body region 10a and a second base body region 10b. The first conductive layer 11 faces the first base body region 10a. The first conductive layer 11 is between the first base body region 10a and the first conductive region 11a in the first direction D1. The second conductive layer 12 faces the second base body region 10b. The second conductive layer 12 is between the second base body region 10b and the second conductive region 12b in the first direction D1.

The base body 10s, the first conductive layer 11, the first conductive region 11a, the first photoelectric conversion layer 21, the first compound region 31a, the second conductive layer 12, the second conductive region 12b, the second photoelectric conversion layer 22, and the second compound region 32b are layered extending along the X-Y plane.

As shown in FIG. 1, the second counter conductive layer 12o may further include a fourth conductive region 12d. The second compound layer 32 may include a fourth compound region 32d. The third compound region 32c is between the fourth conductive region 12d and a part of the second photoelectric conversion layer 22. The third compound region 32c may be in contact with the base body 10s. The fourth compound region 32d is between the fourth conductive region 12d and another part of the second photoelectric conversion layer 22. For example, the fourth conductive region 12d is between the fourth compound region 32d and the third compound region 32c in the second direction D2.

The second compound layer 32 may include a fifth compound region 32e. At least a part of the fifth compound region 32e is between the base body 10s and the fourth conductive region 12d. For example, the fifth compound region 32e is in contact with the base body 10s. In this example, the third compound region 32c and the fourth compound region 32d are connected by the fifth compound region 32e.

As shown in FIG. 1, for example, at least a part of the fourth compound region 32d may be provided between the first conductive layer 11 and the second conductive layer 12. Electrical isolation is effectively performed.

At least a part of the fourth conductive region 12d may be provided between the first conductive layer 11 and the second conductive layer 12. A part of the fourth compound region 32d is between the first conductive layer 11 and a part of the fourth conductive region 12d. A part of the third compound region 32c is between a part of the fourth conductive region 12d and the second conductive layer 12. With such a configuration, electrical isolation is stably performed.

The third compound region 32c may be provided between the first conductive layer 11 and the second conductive layer 12, as described above. The third compound region 32c may be in contact with the base body 10s. The third compound region 32c may be separated from the base body 10s. The third compound region 32c may be in contact with the first conductive layer 11. The third compound region 32c may be separated from the first conductive layer 11. The third compound region 32c may be in contact with the second conductive layer 12. The third compound region 32c may be separated from the second conductive layer 12.

FIG. 3 is a schematic cross-sectional view illustrating a solar cell according to the first embodiment.

FIG. 3 illustrates an enlarged region including a connecting portion of the first cell 11E and the second cell 12E. As shown in FIG. 3, also in a solar cell 111 according to the embodiment, the first conductive layer 11, the first counter conductive layer 11o, the first photoelectric conversion layer 21, the first compound layer 31, the second conductive layer 12, the second counter conductive layer 12o, the second photoelectric conversion layer 22 and the second compound layer 32 are provided. In the solar cell 111, the second counter conductive layer 12o includes a fifth conductive region 12e. Other configurations of the solar cell 111 may be the same as those of the solar cell 110.

The fifth conductive region 12e is between the fourth compound region 32d and the fourth conductive region 12d in the second direction D2. A direction from the fifth conductive region 12e to the fourth conductive region 12d is along the second direction D2.

In this example, the second counter conductive layer 12o further includes a sixth conductive region 12f. The sixth conductive region 12f electrically connects the fifth conductive region 12e with the fourth conductive region 12d. The fifth compound region 32e is provided between the third compound region 32c and the fourth compound region 32d.

Such a configuration may be formed as follows. For example, a groove is provided in the second photoelectric conversion layer 22. A compound film to be the second compound layer 32 is formed inside the groove. A conductive film to be the second counter conductive layer 12o is formed thereon. Thereby, the above configuration is obtained.

As shown in FIG. 3, a length of the second photoelectric conversion layer 22 in the first direction D1 is defined as a third length t3. A length of the third compound region 32c in the second direction D2 is defined as a fourth length t4. The fourth length t4 is shorter than the third length t3.

A length of the fourth conductive region 12d in the second direction D2 is defined as a fifth length t5. The fifth length t5 is shorter than the third length t3. With such a configuration, for example, the region for electrical insulation can be narrowed. This increases the area for photoelectric conversion. It is easy to obtain high efficiency.

In the embodiment, the third length t3 is, for example, not less than 100 nm and not more than 200 µm. The fourth length t4 is, for example, not less than 5 nm and not more than 100 nm. The fifth length t5 is, for example, not less than 30 nm and not more than 1 µm. The third length t3, the fourth length t4 and the fifth length t5 are, for example, thicknesses.

An example of a method for manufacturing the solar cell 111 will be described below.

FIG. 4A to FIG. 4H are schematic cross sectional views illustrating a manufacturing method of the solar cell according to the first embodiment.

As shown in FIG. 4A, a conductive film 11F is provided on the base body 10s.

As shown in FIG. 4B, a part of the conductive film 11F is removed. Thereby, the first conductive layer 11 and the second conductive layer 12 are obtained. A part of the conductive film 11F is removed by, for example, at least one of etching and scribing.

As shown in FIG. 4C, a photoelectric conversion film 20F is provided on the base body 10s, the first conductive layer 11 and the second conductive layer 12. The photoelectric conversion film 20F is formed by sputtering, for example.

As shown in FIG. 4D, a part of the photoelectric conversion film 20F is removed. As a result, a film that becomes the first photoelectric conversion layer 21 and a film that becomes the second photoelectric conversion layer 22 are obtained. A part of the photoelectric conversion film 20F is removed by scribing, for example.

As shown in FIG. 4E, a compound film 30F is formed on the film that will become the first photoelectric conversion layer 21 and on the film that will become the second photoelectric conversion layer 22. The compound film 30F is also formed on the side surface of the film that will become the first photoelectric conversion layer 21 and the side surface of the film that will become the second photoelectric conversion layer 22. The compound film 30F can be formed by vapor deposition, atomic layer deposition, or the like, for example.

As shown in FIG. 4F, a trench T2 is formed. The trench T2 separates the compound film 30F. Thereby, the first compound layer 31 and the second compound layer 32 are obtained from the compound film 30F. The third compound region 32c and the fourth compound region 32d of the second compound layer 32 are obtained. The trench T2 is formed by, for example, scribing.

As shown in FIG. 4G, a conductive film 10G is formed on the processed body. The conductive film 10G is also formed inside the trench T2. Thereby, the third conductive region 12c is formed. The conductive film 10G is also provided between the third compound region 32c and the fourth compound region 32d. Thereby, the fourth conductive region 12d is formed. The conductive film 10G can be formed by vapor deposition, for example.

As shown in FIG. 4H, a part of the conductive film 10G is removed, and a part of the first compound layer 31 is removed. Further, a part of the conductive film 10G and a part of the first photoelectric conversion layer 21 exposed by removing a part of the first compound layer 31 are removed. The recess 21D is formed in the first photoelectric conversion layer 21. The conductive film 10G is divided by the recess 21D. Thereby, the first counter conductive layer 11o (first conductive region 11a) and the second counter conductive layer 12o (second conductive region 12b) are formed. The removal of a part of the conductive film 10G, the removal of a part of the first compound layer 31, and the formation of the recess 21D can be performed, for example, by scribing.

The solar cell 111 is obtained by the above. In the step of FIG. 4D, a configuration may be obtained in which at least a part of the fourth conductive region 12d is not formed according to the width of the groove between the first photoelectric conversion layer 21 and the second photoelectric conversion layer 22. According to the width of the groove between the first photoelectric conversion layer 21 and the second photoelectric conversion layer 22, a configuration in which at least a part of the fifth conductive region 12e is not formed may be obtained.

In the solar cell according to the embodiment, recesses 21D are formed. Thereby, the conductive film 10G (and the first compound layer 31) can be stably removed.

In the solar cell according to the embodiment, for example, the photoelectric conversion layer existing on the first conductive layer 11 is divided by the third conductive region 12c. For example, in the cross section (X-Z cross section) of the solar cell 111, the photoelectric conversion layer existing on the first conductive layer 11 is divided into two or more.

FIG. 5 is a schematic cross-sectional view illustrating a solar cell according to the first embodiment.

As shown in FIG. 5, also in a solar cell 112 according to the embodiment, the first conductive layer 11, the first counter conductive layer 11o, the first photoelectric conversion layer 21, the first compound layer 31, the second conductive layer 12, the second counter conductive layer 12o, the second photoelectric conversion layer 22 and the second compound layer 32 are provided. In the solar cell 112, a part of the first conductive layer 11 overlaps the fifth compound region 32e and the sixth conductive region 12f in the Z-axis direction. Other configurations of the solar cell 112 may be the same as those of the solar cell 111.

In the solar cell 112, a part of the first conductive layer 11 is provided between the base body 10s and the fifth compound region 32e in the Z-axis direction. A part of the first conductive layer 11 is provided between the base body 10s and the sixth conductive region 12f in the Z-axis direction. A part of the fifth compound region 32e is provided between the first conductive layer 11 and the second conductive layer 12. A part of the sixth conductive region 12f may be provided between the first conductive layer 11 and the second conductive layer 12. A part of the third compound region 32c is provided between the first conductive layer 11 and the second conductive layer 12.

In the embodiment, at least one of the first photoelectric conversion layer 21 and the second photoelectric conversion layer 22 may include a first oxide. The first oxide may include, for example, cuprous oxide. The first oxide may include, for example, a cuprous oxide composite oxide.

In one example, the first oxide includes, for example, an oxide represented by CuₐM1_{b}O_{c}. "M1" includes, for example, at least one selected from the group consisting of Sn, Sb, Ag, Li, Na, K, Cs, Rb, Al, In, Zn, Mg and Ca. For example, "a", "b" and "c" may satisfy 1.80≤a≤2.01, 0.00≤b≤0.20, and 0.98≤c≤1.02.

The concentration of the first oxide in at least one of the first photoelectric conversion layer 21 and the second photoelectric conversion layer 22 may be, for example, 90 wt% or higher. The concentration of the first oxide in at least one of the first photoelectric conversion layer 21 and the second photoelectric conversion layer 22 may be, for example, 95 wt% or more. The concentration of the first oxide in the first photoelectric conversion layer 21 and the second photoelectric conversion layer 22 may be, for example, 98 wt% or higher.

At least one of the first photoelectric conversion layer 21 and the second photoelectric conversion layer 22 preferably does not substantially include Cu or CuO. Cu or CuO are heterophasic.

In the embodiment, at least one of the first compound layer 31 and the second compound layer 32 may include a second oxide. For example, the second oxide includes an oxide including at least one selected from the group consisting of Ga, Al, B, In, Ti, Zn, Hf, Zr, Sn, Si and Ge. For example, the photoelectric conversion layer may include the first oxide described above. In this case, for example, when the first compound layer 31 and the second compound layer 32 are formed, the second oxide is easy to pull out oxygen that is bound to Cu of the first oxide included in the photoelectric conversion layer.

In the embodiment, at least one of the first compound layer 31 and the second compound layer 32 may include sulfide. The sulfide included in at least one of the first compound layer 31 and the second compound layer 32 may include Cu diffused from the first oxide.

In the embodiment, when the first compound layer 31 and the second compound layer 32 include an oxide including Ga, a ratio of Ga to a metal element included in the oxide (the total amount of metal elements) is preferably 50 atom% or more. The first compound layer 31 and the second compound layer 32 may have a stacked structure.

The base body 10s may be, for example, a light - transmitting substrate. The base body 10s may include, for example, a substrate including an organic material. The organic material includes, for example, at least one selected from the consisting of acrylic, polyimide, polycarbonate, polyethylene terephthalate (PET), polypropylene (PP), fluorine-based resins (polytetrafluoroethylene (PTFE), perfluoroethylene propene copolymer (FEP), ethylenetetrafluoroethylene copolymer ( ETFE), polychlorotrifluoroethylene (PCTFE), perfluoroalkoxyalkane (such as PFA), polyarylate, polysulfone, polyethersulfone, and polyetherimide.

The base body 10s may include a substrate including inorganic material. The inorganic material includes, for example, at least one selected from the group consisting of soda lime glass, white sheet glass, chemically strengthened glass and quartz.

The base body 10s may include a layer including the above organic material and a layer including the above inorganic material. These layers are stacked. In the embodiment, the base body 10s may be omitted.

For example, the first counter conductive layer 11o is light-transmissive. The first counter conductive layer 11o preferably includes an oxide light-transmitting conductive film (semiconductor conductive film). The oxide light-transmitting conductive film includes, for example, at least one selected from the group consisting of Indium Tin Oxide (ITO), Aluminum-doped Zinc Oxide (AZO), Boron-doped Zinc Oxide (BZO), Gallium Gallium-doped Zinc Oxide (GZO), Doped Tin Oxide, Titanium-doped Indium Oxide (ITiO), Indium Zinc Oxide (IZO), Indium Gallium Zinc Oxide, Indium Gallium Zinc Oxide (IGZO) and Hydrogen-doped Indium Oxide (IOH). The oxide light-transmitting conductive film may be a stacked film including multiple films.

The first conductive layer 11 may, for example, be light-transmissive. The first conductive layer 11 may not be light-transmissive. The first conductive layer 11 may include a metal film. The metal film includes, for example, at least one selected from the group consisting of Au and Ag.

In doped tin oxide, the dopant includes, for example, at least one selected from the group consisting of In, Si, Ge, Ti, Cu, Sb, Nb, Ta, W, Mo, F and Cl.

The first conductive layer 11 preferably includes doped tin oxide. When the first conductive layer 11 includes the doped tin oxide, for example, it is preferable that the doped tin oxide is in direct contact with the photoelectric conversion layer. When the first conductive layer 11 includes a doped tin oxide film, the doped tin oxide film is preferably provided on a surface of the first conductive layer 11 facing the photoelectric conversion layer side. Preferably, the doped tin oxide film is in direct contact with the photoelectric conversion layer.

The first conductive layer 11 preferably includes, for example, a doped tin oxide film including at least one selected from the group consisting of In, Si, Ge, Ti, Cu, Sb, Nb, Ta, W, Mo, F and Cl. In the doped tin oxide film, a concentration of at least one selected from the group consisting of In, Si, Ge, Ti, Cu, Sb, Nb, Ta, W, Mo, F and Cl is preferably 10 atomic % or less with respect to tin included in the tin oxide film.

The first conductive layer 11 may include, for example, a stacked film including an oxide light-transmitting conductive film and a metal film. The thickness of the metal film is preferably 10 nm or less. The metal (including alloy) included in the metal film includes at least one selected from the group consisting of Mo, Au, Cu, Ag, Al, Ta and W, for example.

The first conductive layer 11 may include an interlayer conductive film. The interlayer conductive film is provided between the oxide light-transmitting conductive film and the base body 10s and between the oxide light-transmitting conductive film and the photoelectric conversion layer. The interlayer conductive film may be dot-shaped, line-shaped, or mesh-shaped, for example. The interlayer conductive film preferably includes, for example, at least one selected from the group consisting of a metal, an alloy, graphene, conductive nitride and conductive oxide. The aperture ratio of the interlayer conductive film is preferably 50% or more, for example. The interlayer conductive film includes at least one selected from the group consisting of Mo, Au, Cu, Ag, Al, Ta and W, for example.

When the first conductive layer 11 includes a metal film, the thickness of the metal film is preferably 5 nm or less, for example. For example, it is easy to obtain high light transmittance. When the first conductive layer 11 includes a line-shaped or mesh-shaped metal film, the thickness of the metal film may exceed 5 nm.

For example, the first conductive layer 11 may be formed by forming an oxide light-transmitting conductive film on the base body 10s. The oxide light-transmitting conductive film may be formed, for example, by sputtering. The first conductive layer 11 may be formed by forming a film including a metal on the base body 10s. The metal-including film may be patterned as desired. For example, a mesh-like metal or a line-like metal can be obtained.

The second counter conductive layer 12o may include the same material and structure as the first counter conductive layer 11o. The second conductive layer 12 may include the same material and structure as the first conductive layer 11.

### Second embodiment

A multi-junction type solar cell according to a second embodiment includes the solar cell according to the first embodiment (e.g., solar cell 110, solar cell 111, or solar cell 112).

FIG. 6 is a schematic cross sectional view illustrating a multi-junction type solar cell according to the second embodiment.

As shown in FIG. 6, a multi-junction type solar cell 200 according to the embodiment includes a first solar cell 101 and a second solar cell 201. The first solar cell 101 is the solar cell according to the first embodiment (for example, solar cell 110, solar cell 111, or solar cell 112). The first solar cell 101 and the second solar cell 201 are stacked together. For example, light 81 passes through the first solar cell 101 and enters the second solar cell 201. In the multi-junction type solar cell 200, the number of stacked solar cells is two or more and is arbitrary.

The bandgap of the photoelectric conversion layer of the second solar cell 201 is smaller than the bandgap of the photoelectric conversion layer of the first solar cell 101. The bandgap of the photoelectric conversion layer of the first solar cell 101 is, for example, 2.10 eV or more. The bandgap of the photoelectric conversion layer of the second solar cell 201 is, for example, not less than 1.0 eV and not more than 1.4 eV. The photoelectric conversion layer of the second solar cell 201 includes, for example, at least one of a compound semiconductor layer and crystalline silicon. The compound semiconductor layer includes, for example, at least one of a CIGS-based compound, a CIT-based compound, and a CdTe-based compound. The content ratio of In in the CIGS-based compound is high.

The first solar cell 101 transmits most of the light in the absorption band wavelength of the photoelectric conversion layer of the second solar cell 201. A decrease in conversion efficiency in the second solar cell 201 can be suppressed. A multi-junction type solar cell with high efficiency is obtained.

### Third embodiment

A solar cell module according to a third embodiment includes the multi-junction type solar cell according to the second embodiment.

FIG. 7 is a schematic perspective view illustrating a solar cell module according to a third embodiment.

As shown in FIG. 7, a solar cell module 300 according to the embodiment includes a first solar cell module 301 and a second solar cell module 302. The first solar cell module 301 and the second solar cell module 302 are stacked together. Light passing through the first solar cell module 301 enters the second solar cell module 302. The first solar cell module 301 includes the solar cell according to the first embodiment (e.g., solar cell 110, solar cell 111, or solar cell 112). The first solar cell module 301 includes, for example, the second solar cell 201.

FIG. 8 is a schematic cross sectional view illustrating a solar cell module according to the third embodiment.

In FIG. 8, the structure of the first solar cell module 301 is simplified and illustrated. In FIG. 8, a compound layer for electrical insulation and the like are omitted. In FIG. 8, the structure of the second solar cell module 302 is omitted. In the second solar cell module 302, the structure of the solar cell module may be appropriately applied according to the photoelectric conversion layer of the solar cell used.

As shown in FIG. 8, the solar cell module 300 includes multiple sub-modules 303. One of the multiple sub-modules 303 is shown surrounded by dashed lines. The multiple sub-modules 303 are electrically connected in parallel or electrically in series with each other. One of the multiple sub-modules 303 includes multiple solar cells 100 (solar cells). Multiple solar cells 100 are connected in series. The multiple solar cells 100 are arranged, for example, along the X-Y plane.

In the multiple solar cells 100, a first separation region P1 and a second division region P2 are provided. The first separation region P1 and the second division region P2 correspond to, for example, scribe regions. The multiple solar cells 100 are divided by first separation regions P1 and second division regions P2.

In one of the multiple solar cells 100, there is a photoelectric conversion layer 20A between the first electrode 11A and the second electrode 12A. One first electrode 11A of the multiple solar cells 100 is electrically connected to another one second electrode 12A of the multiple solar cells 100. Another one of the multiple solar cells 100 is next to one of the multiple solar cells 100. The first electrode 11A is, for example, the first conductive layer 11 or the second conductive layer 12. The second electrode 12A is, for example, the first counter conductive layer 11o or the second counter conductive layer 12o. As shown in FIG. 8, connection electrodes 304 electrically connected to these electrodes may be provided. These electrodes may be electrically connected to the outside via the connection electrodes 304. The connection electrode 304 is, for example, a terminal.

If the output voltages of multiple solar cell modules are different, the current may flow back to the solar cell module with the lower voltage. This generates heat. For example, the output of the solar cell module is reduced.

In the embodiment, solar cells suitable for each wavelength band may be used. A higher power generation efficiency can be obtained than when the top-cell solar cell and the bottom-cell solar cell are used alone. For example, the overall output of the solar cell module is increased.

If the conversion efficiency of the entire solar cell module is high, the percentage of energy that becomes heat in the irradiated light energy can be reduced. For example, the temperature of the entire solar cell module can be suppressed. A decrease in efficiency due to temperature rise can be suppressed.

### Fourth embodiment

The solar cell power generation system according to the fourth embodiment includes the solar cell module according to the third embodiment. The photovoltaic power generation system is used, for example, as a generator for generating power. For example, the photovoltaic power generation system uses a solar cell module to generate electricity. The photovoltaic power generation system may include, for example, a solar cell module and a power converter. The solar cell module generates electricity. The power converter converts the generated electricity into electric power. The photovoltaic power generation system may include, for example, at least one of a power storage part or a load. The storage part stores the generated electricity. The load consumes power.

FIG. 9 is a schematic view illustrating the solar cell power generation system according to the fourth embodiment.

As shown in FIG. 9, a photovoltaic power generation system 400 includes a solar cell module 401 (for example, a solar cell module 300), a power conversion device 402, a storage battery 403, and a load 404. One of the storage battery 403 and the load 404 may be omitted. The load 404 may utilize the electric energy stored in the storage battery 403. The power conversion device 402 includes at least one of a circuit or an element. At least one of the circuit or the element performs power conversion. Power conversion includes at least one of transformation and DC / AC conversion. The configuration corresponding to the configuration of the generated voltage, the storage battery 403, and the load 404 may be applied to the power conversion device 402.

The solar cell module 401 (for example, the solar cell module 300) includes a sub-module (first solar cell module 301). The solar cells included in the sub-module (first solar cell module 301) generate electricity. The electric energy of power generation is converted by the power conversion device 402. The converted electric energy is stored in the storage battery 403. Alternatively, the converted electrical energy is consumed by the load 404. The solar cell module 401 may be provided with a solar tracking drive device that causes the solar cell module 401 to follow the movement of the sun. The solar cell module 401 may be provided with a condenser that collects sunlight. A device or the like for improving the power generation efficiency may be added to the solar cell module 401.

The photovoltaic power generation system 400 may be used for real estate such as a residence, a commercial facility, or a plant. The photovoltaic power generation system 400 may be used, for example, for a moving property such as a vehicle, an aircraft, or an electronic device.

An application example of the photovoltaic power generation system 400 will be described.

FIG. 10 is a schematic diagram showing an application example of the solar cell power generation system according to the fourth embodiment.

As shown in FIG. 10, the solar cell power generation system is used in a vehicle 500. The vehicle 500 includes a vehicle body 501, a solar cell module 502, a power conversion device 503, a storage battery 504, a motor 505, and a wheel 506.

For example, the solar cell module 502 is provided on the upper part of the vehicle body 501. The electric power generated by the solar cell module 502 is converted by the power conversion device 503. The electric power is stored in the storage battery 504. Alternatively, the electric power is consumed by a load such as a motor 505. The wheel 506 is rotated by the motor 505 using the electric power supplied from the solar cell module 502 or the storage battery 504. As a result, the vehicle 500 moves.

The solar cell module 502 may include a non-multi-junction type solar cell. The solar cell module 502 may be formed of only the first solar cell module including the light-transmitting solar cell 100. At least a part of the solar cell module 502 may be transparent. In this case, the solar cell module 502 may be provided as a window on a side surface of the vehicle body 501.

The embodiments may include the following configurations (for example, technical proposals).

### Configuration 1

A solar cell, comprising:
a first conductive layer;
a first counter conductive layer including a first conductive region, a direction from the first conductive layer to the first conductive region being along a first direction; and
a first photoelectric conversion layer including a first photoelectric conversion region and a second photoelectric conversion region, the first photoelectric conversion region being provided between the first conductive layer and the first conductive region in the first direction, the second photoelectric conversion region not overlapping the first conductive region in the first direction, a second thickness of the second photoelectric conversion region along the first direction being thinner than a first thickness of the first photoelectric conversion region along the first direction.

### Configuration 2

The solar cell according to Configuration 1, further comprising:
a second conductive layer, a second direction from the first conductive layer to the second conductive layer crossing the first direction;
a second counter conductive layer including a second conductive region and a third conductive region, a direction from the second conductive layer to the second conductive region being along the first direction, a direction from the first conductive region to the second conductive region being along the second direction, the third conductive region electrically connecting the second conductive region to the first conductive layer; and
a second photoelectric conversion layer provided between the second conductive layer and the second conductive region, the second photoelectric conversion region being between the first photoelectric conversion region and the second photoelectric conversion layer in the second direction, at least a part of the third conductive region being between the second photoelectric conversion region and the second photoelectric conversion layer in the second direction.

### Configuration 3

The solar cell according to Configuration 2, wherein
the second photoelectric conversion region does not overlap the second conductive region in the first direction.

### Configuration 4

The solar cell according to Configuration 3, further comprising:
a first member including a same material as a material included in the first photoelectric conversion layer,
the first member being between the second photoelectric conversion region and the third conductive region in the second direction.

### Configuration 5

The solar cell according to any one of Configurations 2 to 4, wherein
a first ratio of an absolute value of a difference between the first thickness and the second thickness to the first thickness is not less than 0.2 and not more than 0.99.

### Configuration 6

The solar cell according to any one of Configurations 2 to 5, wherein
a second ratio of the second thickness to a distance along the second direction between the first conductive region and the second conductive region is not less than 0.02 and not more than 0.5.

### Configuration 7

The solar cell according to any one of Configurations 2 to 6, further comprising:
a first compound layer; and
a second compound layer,
the first compound layer including a first compound region,
the first compound region being provided between the first photoelectric conversion layer and the first conductive region,
the second compound layer including a second compound region and a third compound region,
the second compound region being provided between the second photoelectric conversion layer and the second conductive region, and
at least a part of the third compound region being between the first conductive layer and the second conductive layer in the second direction.

### Configuration 8

The solar cell according to Configuration 7, wherein
the first compound region does not overlap the second photoelectric conversion region in the first direction.

### Configuration 9

The solar cell according to Configuration 7 or 8, wherein
at least one of the first compound layer or the second compound layer includes an oxide including at least one selected from the group consisting of Ga, Al, B, In, Ti, Zn, Hf, Zr, Sn, Si and Ge.

### Configuration 10

The solar cell according to any one of Configurations 7 to 9, wherein
the second counter conductive layer further includes a fourth conductive region,
the second compound layer includes a fourth compound region,
the third compound region is between the fourth conductive region and a part of the second photoelectric conversion layer, and
the fourth compound region is between the fourth conductive region and an other part of the second photoelectric conversion layer.

### Configuration 11

The solar cell according to Configuration 10, wherein
the fourth conductive region is between the fourth compound region and the third compound region in the second direction.

### Configuration 12

The solar cell according to Configuration 10 or 11, wherein
at least a part of the fourth compound region is between the first conductive layer and the second conductive layer.

### Configuration 13

The solar cell according to any one of Configurations 10 to 12, wherein
at least a part of the fourth conductive region is between the first conductive layer and the second conductive layer.

### Configuration 14

The solar cell according to any one of Configurations 10 to 13, wherein
the second counter conductive layer further includes a fifth conductive region,
the fifth conductive region is between the fourth compound region and the fourth conductive region in the second direction, and
a direction from the fifth conductive region to the fourth conductive region is along the second direction.

### Configuration 15

The solar cell according to Configuration 14, wherein
the second counter conductive layer further includes a sixth conductive region, and
the sixth conductive region electrically connects the fifth conductive region to the fourth conductive region.

### Configuration 16

The solar cell according to any one of Configurations 2 to 15, wherein
at least one of the first photoelectric conversion layer or the second photoelectric conversion layer includes copper and oxygen.

### Configuration 17

The solar cell according to any one of Configurations 2 to 15, wherein
at least one of the first photoelectric conversion layer or the second photoelectric conversion layer includes Cu₂O.

### Configuration 18

The solar cell according to any one of Configurations 2 to 15, further comprising a base body,
the base body including a first surface, the first surface including a first base body region and a second base body region,
the first conductive layer being between the first base body region and the first conductive region in the first direction, and
the second conductive layer being between the second base body region and the second conductive region in the first direction.

### Configuration 19

A multi-junction type solar cell, comprising:
the solar cell according to Configuration 1.

### Configuration 20

A solar cell module, comprising:
the multi-junction type solar cell according to Configuration 19.

### Configuration 21

A solar cell power generation system, comprising:
the solar cell module according to Configuration 20.

According to the embodiments, a solar cell, a multi-junction type solar cell, a solar cell module, and a solar cell power generation system capable of improving efficiency are provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in solar cells such as conductive layers, photoelectric conversion layers, compound layers, base bodies, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all solar cells, multi-junction type solar cells, solar cell modules, and solar cell power generation systems practicable by an appropriate design modification by one skilled in the art based on the solar cells, the multi-junction type solar cells, the solar cell modules, and the solar cell power generation systems described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

### [Explanation of Letters or Numerals]

10F···first surface, 10G···conductive film, 10a, 10b···first, second base body region, 10s···base body, 11, 12···first, second conductive layer, 11A, 12A···first, second electrode, 11E, 12E···first, second cell, 11F···conductive film, 11a···first conductive region, 11o, 12o···first, second counter conductive layer, 12b~12f···second~sixth conductive region, 20A···photoelectric conversion layer, 20F···photoelectric conversion film, 21, 22···first, second photoelectric conversion layer, 30F···compound film, 31, 32···first, second compound layer, 31a···first compound region, 32b~32e···second~fifth compound region, 81···light, 100, 110, 111, 112, 119···solar cell, 101···first solar cell, 200···multi-junction type solar cell, 201···second solar cell, 300···solar cell module, 301, 302···first, second solar cell module, 303···sub-module, 304···connection electrode, 400···photovoltaic power generation system, 401···solar cell module, 402···power conversion device, 403···storage battery, 404···load, 500···vehicle, 501···vehicle body, 502···solar cell module, 503···power conversion device, 504···storage battery, 505···motor, 506···wheel, D1, D2···first, second direction, J1···current density, P1~P3···separation region, T2···trench, V1···voltage, t1~t3···length, w1···distance

## Claims

1. A solar cell, comprising:
a first conductive layer;
a first counter conductive layer including a first conductive region, a direction from the first conductive layer to the first conductive region being along a first direction; and
a first photoelectric conversion layer including a first photoelectric conversion region and a second photoelectric conversion region, the first photoelectric conversion region being provided between the first conductive layer and the first conductive region in the first direction, the second photoelectric conversion region not overlapping the first conductive region in the first direction, a second thickness of the second photoelectric conversion region along the first direction being thinner than a first thickness of the first photoelectric conversion region along the first direction.

2. The solar cell according to claim 1, further comprising:
a second conductive layer, a second direction from the first conductive layer to the second conductive layer crossing the first direction;
a second counter conductive layer including a second conductive region and a third conductive region, a direction from the second conductive layer to the second conductive region being along the first direction, a direction from the first conductive region to the second conductive region being along the second direction, the third conductive region electrically connecting the second conductive region to the first conductive layer; and
a second photoelectric conversion layer provided between the second conductive layer and the second conductive region, the second photoelectric conversion region being between the first photoelectric conversion region and the second photoelectric conversion layer in the second direction, at least a part of the third conductive region being between the second photoelectric conversion region and the second photoelectric conversion layer in the second direction.

3. The solar cell according to claim 2, wherein
the second photoelectric conversion region does not overlap the second conductive region in the first direction.

4. The solar cell according to claim 3, further comprising:
a first member including a same material as a material included in the first photoelectric conversion layer,
the first member being between the second photoelectric conversion region and the third conductive region in the second direction.

5. The solar cell according to any one of claims 2 to 4, wherein
a first ratio of an absolute value of a difference between the first thickness and the second thickness to the first thickness is not less than 0.2 and not more than 0.99.

6. The solar cell according to any one of claims 2 to 5, wherein
a second ratio of the second thickness to a distance along the second direction between the first conductive region and the second conductive region is not less than 0.02 and not more than 0.5.

7. The solar cell according to any one of claims 2 to 6, further comprising:
a first compound layer; and
a second compound layer,
the first compound layer including a first compound region,
the first compound region being provided between the first photoelectric conversion layer and the first conductive region,
the second compound layer including a second compound region and a third compound region,
the second compound region being provided between the second photoelectric conversion layer and the second conductive region, and
at least a part of the third compound region being between the first conductive layer and the second conductive layer in the second direction.

8. The solar cell according to claim 7, wherein
the first compound region does not overlap the second photoelectric conversion region in the first direction.

9. The solar cell according to claim 7 or 8, wherein
at least one of the first compound layer or the second compound layer includes an oxide including at least one selected from the group consisting of Ga, Al, B, In, Ti, Zn, Hf, Zr, Sn, Si and Ge.

10. The solar cell according to any one of claims 7 to 9, wherein
the second counter conductive layer further includes a fourth conductive region,
the second compound layer includes a fourth compound region,
the third compound region is between the fourth conductive region and a part of the second photoelectric conversion layer, and
the fourth compound region is between the fourth conductive region and an other part of the second photoelectric conversion layer.

11. The solar cell according to claim 10, wherein
the fourth conductive region is between the fourth compound region and the third compound region in the second direction.

12. The solar cell according to claim 10 or 11, wherein
at least a part of the fourth compound region is between the first conductive layer and the second conductive layer.

13. The solar cell according to any one of claims 10 to 12, wherein
at least a part of the fourth conductive region is between the first conductive layer and the second conductive layer.

14. The solar cell according to any one of claims 10 to 13, wherein
the second counter conductive layer further includes a fifth conductive region,
the fifth conductive region is between the fourth compound region and the fourth conductive region in the second direction, and
a direction from the fifth conductive region to the fourth conductive region is along the second direction.

15. The solar cell according to claim 14, wherein
the second counter conductive layer further includes a sixth conductive region, and
the sixth conductive region electrically connects the fifth conductive region to the fourth conductive region.

16. The solar cell according to any one of claims 2 to 15, wherein
at least one of the first photoelectric conversion layer or the second photoelectric conversion layer includes copper and oxygen.

17. The solar cell according to any one of claims 2 to 15, wherein
at least one of the first photoelectric conversion layer or the second photoelectric conversion layer includes Cu₂O.

18. The solar cell according to any one of claims 2 to 15, further comprising a base body,
the base body including a first surface, the first surface including a first base body region and a second base body region,
the first conductive layer being between the first base body region and the first conductive region in the first direction, and
the second conductive layer being between the second base body region and the second conductive region in the first direction.

19. A multi-junction type solar cell, comprising:
the solar cell according to claim 1.

20. A solar cell module, comprising:
the multi-junction type solar cell according to claim 19.

21. A solar cell power generation system, comprising:
the solar cell module according to claim 20.
